# EUROPEAN PATENT SPECIFICATION

(11) **EP 2 556 015 B1**
(45) Date of publication and mention of the grant of the patent: **10.08.2016**
(21) Application number: 11766241.1
(22) Date of filing: 05.04.2011
(51) Int. Cl.: B81C 99/00, B82Y 10/00, B82Y 20/00, G01Q 90/00, H01L 21/20, H01L 21/265, B81C 1/00

(54) **FREE FORM PRINTING OF SILICON MICRO- AND NANOSTRUCTURES**
FREIFORMBESTÜCKUNG VON SILIZIUM-MIKRO- UND NANOSTRUKTUREN
IMPRESSION À FORME LIBRE DE MICRO- ET DE NANO-STRUCTURES EN SILICIUM

(30) Priority: 09.04.2010 SE 1000352
(43) Date of publication of application: 13.02.2013
(73) Proprietor: Niklaus, Frank, 183 61 Täby (SE); Fischer, Andreas, 113 64 Stockholm (SE)
(72) Inventor: Niklaus, Frank, 183 61 Täby (SE); Fischer, Andreas, 113 64 Stockholm (SE)
(74) Representative: Brann AB
(86) International application number: PCT/SE2011/050401
(87) International publication number: WO 2011/126438

(56) References cited:
- EP-A2- 1 209 689
- DE-A1- 19 530 944
- US-A1- 2007 065 595
- US-A1- 2007 065 595
- US-B2- 7 095 021
- SCHMIDT B ET AL: "Writing FIB implantation and subsequent anisotropic wet chemical etching for fabrication of 3D structures in silicon", SENSORS AND ACTUATORS A, ELSEVIER SEQUOIA S.A., LAUSANNE, CH, vol. 61, no. 1-3, 1 June 1997 (1997-06-01) , pages 369-373, XP026715081, ISSN: 0924-4247, DOI: 10.1016/S0924-4247(97)80291-9 [retrieved on 1997-06-01]
- SCHMIDT B. ET AL: 'Writing FIB implantation and subsequent anisotropic wet chemical etching for fabrication of 3D structures in silicon' SENSORS AND ACTUATORS A vol. 61, 1997, pages 369 - 373, XP026715081

## Description

The present invention relates to MEMS processing in general and to a new method of making three-dimensional structures in silicon in particular.

### Background of the invention

The success of manufacturing industry crucially depends on having a leading position in technology, which is developed through research and innovation. Many leading companies in e.g. automotive, automation, medical, telecommunication and security industries critically depend on micro-and nano-structured components in their products or manufacture such components. The vast majority of available micro-and nano-manufacuring technologies, specifically the ones emerging from the IC industry, are designed to implement two-dimensional integrated circuit structures at very high production volumes. However, many micro- and nano-electromechical system (MEMS and NEMS) components as well as emerging photonic crystal structures are three-dimensional (3D) in their nature. It is often difficult to implement these devices with the existing micro-and nanomanufacuring technologies and many complex 3D designs can not be implemented with the existing technologies.

Simple MEMS metal beam structures with dimensions in the 20-µm-range have been fabricated using a modified ink-jet printing technology. Although inexpensive, this technology is limited with respect to the achievable smallest resolution and the selection of materials. Laser assisted chemical vapour deposition for the fabrication of three-dimensional microstructures is known from the prior art. Layered 3D micro- and nanostructure have also been fabricated using FIB-assisted deposition of various materials such as metals and insulators. However, the selection and quality of the available materials with these approaches is limited and it is not possible to fabricate complex 3D microstructures that contain recesses and undercuts. Laser-based direct writing of polymeric 3D micro- and nano-structures using photo-curable polymers in combination with subsequent dissolving the unexposed, no-crosslinked polymer areas has been successfully demonstrated for applications such as photonic crystal structures. This approach is limited to polymers and techniques have been proposed to use the 3D polymer structures as templates for polymer substitution processes to obtain non-polymeric photonic crystals. Also here the selection and quality of materials with this approach is limited.

3D photonic crystals made of poly-crystalline silicon have been implemented by repeated deposition of poly-crystalline silicon and SiO₂, patterning and planarization using tradition semiconductor processes such as lithography and chemical-mechanical polishing (CMP). The poly-Si structures were finally freeetched by removing the SiO₂ with HF wet etching. However, is not easily possible to automate this approach in an efficient way for practical use. Simple mono-crystalline silicon membranes with thicknesses in the tenth of nanometer-range have been defined by localized FIB exposure and by localized FIB exposure in combination with FIB drilling of a connected hole to make these surfaces etch-resistant against KOH wet etching or against reactive ion etching. The resulting etching selectivity between the silicon that is implanted with ions as compared to the untreated silicon enables the formation of simple membrane structures.

In the literature there have been described schemes for FIB implantation and selective KOH etching or selective reactive ion (dry) etching to provide three-dimensional structures. However, no repeated layer deposition and FIB implantation is disclosed. Examples of such schemes are given in the following articles:
B. Schmidt, L. Bischoff, J. Teichert, "Writing FIB implantation and subsequent anisotropic wet chemical etching for fabrication of 3D structures in silicon", Sensors and Actuators A, Vol.61, No. 1-3, pp.369-373, 1997.
J. Brugger, G. Beljakovic, M. Despont, N.F. de Rooij, P. Vettiger, "Silicon Micro/Nanomechanical Device Fabrication Based on Focused Ion Beam Surface Modification and KOH Etching", Microelectronic Engineering, Vol.35, No.1, pp.401-404, 1997.
H.X. Qian, W. Zhou, J. Miao, Lennie E.N. Lim, X.R. Zeng, "Fabrication of Si microstructures using focused ion beam implantation and reactive ion etching", Journal of Micromechanics and Microengineering, Vol.18, 035003, 2008.

EP 1 209 689 B1 discloses a method of making a structure comprising irradiation of a silicon substrate with a focussed ion beam and subsequently etching away non-irradiated material.

### Summary of the invention

The object of the invention is to enable the manufacture of free-form 3D silicon structures with critical feature sizes in the nanometer range and in the micrometer range, typically below 10 µm.

This object is achieved with the method as claimed in claim 1, namely by a method of making a three-dimensional structure in semiconductor material, comprising the steps of providing a substrate having at least a surface comprising semiconductor material; optionally exposing selected areas of the surface of the substrate to a focussed ion beam whereby the ions are implanted in the semiconductor material in said selected areas; depositing a layer of a material selected from the group consisting of mono-crystalline, poly-crystalline or amorphous semiconductor material, on the substrate surface; repeating the steps of exposing to a focussed ion beam and depositing material until a desired structure is defined by the exposed areas; selective etching of material in the structure defined by the focussed ion beam so as to provide a three-dimensional structure.

The present invention achieves this object by providing entirely new ways of implementing silicon 3D structures for MEMS, NEMS and photonic crystal components that can be arbitrarily shaped in all three dimensions.

This technology will have potential applications e.g. for the implementation of mono-crystalline silicon 3D photonic crystals and for micro and nanosystem applications such as three-axis inertial sensors with identical sensitivity in all three axis. The methods according to the invention resemble laser-based stereo-lithography techniques for fabrication of 3D polymer components and to three-dimensional printing techniques.

In a particular aspect the present invention relates to methods for the fabrication of high-resolution 3D structures made of mono-crystalline, poly-crystalline and amorphous silicon, and/or mono-crystalline, poly-crystalline and amorphous SiGe. Mono-crystalline silicon is the preferred material for MEMS, NEMS and photonic crystal components due to the superior mechanical, optical and electrical properties of silicon.

In preferred embodiments epitaxial silicon growth is employed in combination with ion implantation by direct focussed ion beam (FIB) writing and subsequent selective silicon etching, thereby obtaining layered 3D structures that can be arbitrarily shaped in all three dimensions.

According to the invention there are also provided micro and nano-devices fabricated according to the method according to the invention.

In a further aspect the invention provides a technology tool that, based on a 3D CAD model, will enable to build up free-form 3D MEMS, NEMS or photonic crystal components made of mono-crystalline silicon at acceptable throughput and cost. The apparatus is defined in claim 9.

### Brief Description of the Drawings

The invention will be described in detail below with reference to the appended drawings in which
Figures 1a-c shows (a) 3D polymeric photonic crystal structures, (b) 3D poly-crystalline silicon photonic crystal structures and (c) nano-mechanical structures defined by ion implantation and hole drilling using FIB and subsequent KOH free-etching of the membranes;
Figures 2a-f shows the new concept to form arbitrarily shaped silicon 3D MEMS, NEMS and photonic structures by local implantation of ions using FIB and subsequent selective etching; and
Figure 3 schematically illustrates an apparatus according to the invention.

### Detailed Description

Prior art teaches i.a. stereo-lithography based on direct laser writing in a photosensitive polymer and 3D printing of mechanical 3D models with a functional and a sacrificial support material. These and similar technologies have been developed over the past 20-30 years and are extensively used for the manufacturing of macro-models, prototypes and production parts made of polymers or sintered metals.

The prior art referenced in the background section teaches use of FIB on silicon and etching to provide 3D structures but in these cases the design freedom in shaping the 3D structures is very limited.

The present invention is generally applicable to semiconductor processing and relates to a method of making a three-dimensional structure in semiconductor material. The method comprises providing a substrate having at least a surface comprising semiconductor material. Optionally selected areas of the surface of the substrate are exposed to a focussed ion beam whereby the ions are implanted in the semiconductor material in said selected areas. Then a layer of a material selected from the group consisting of mono-crystalline, poly-crystalline or amorphous semiconductor material, is deposited on the substrate surface. The steps of exposing to a focussed ion beam and depositing material are repeated until a desired structure is defined by the exposed areas. Finally, the material in the structure defined by the focussed ion beam are subjected to selective etching so as to provide a three-dimensional structure.

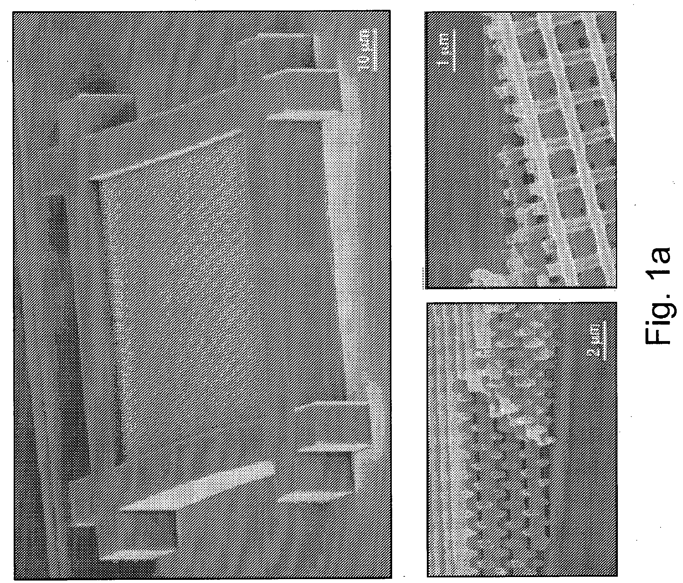

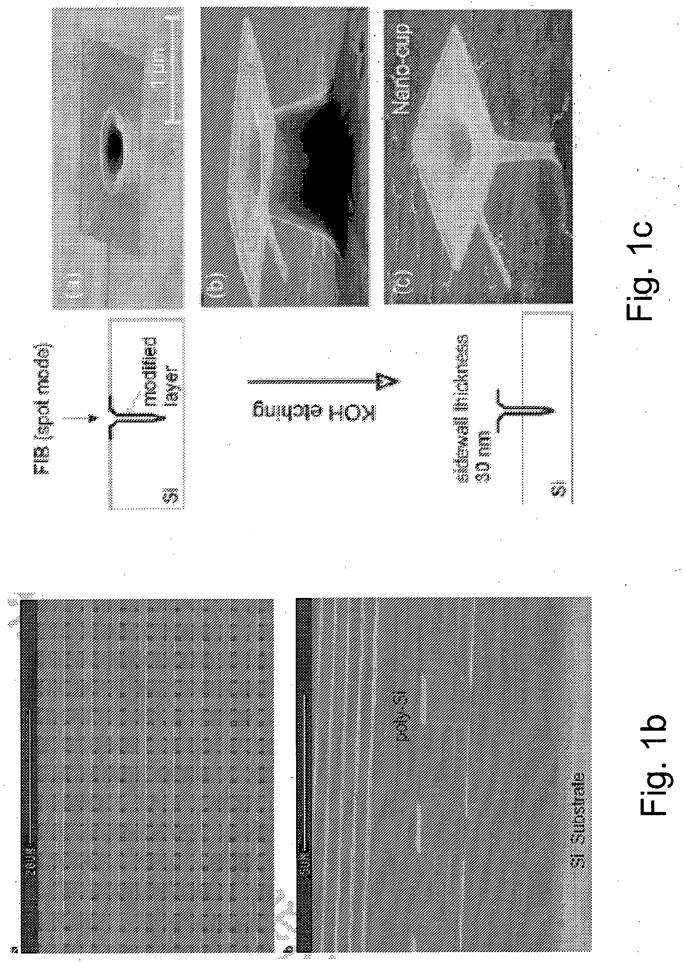

A device made with the method according to the invention is illustrated in Fig. 1 which shows (a) 3D polymeric photonic crystal structures, (b) 3D poly-crystalline silicon photonic crystal structures and (c) nano-mechanical structures defined by ion implantation and hole drilling using FIB and subsequent KOH free-etching of the membranes.

According to the present invention the FIB implantation technology described by Schmidt et al, Brugger et al, and Qian et al (vide supra) has been extended to enable creating entirely new types of mono-crystalline and/or poly-silicon free-form 3D structures. This can be achieved by depositing multi-layered silicon structures and locally implant ions in the silicon by FIB writing. The structures defined in this way can be selectively etched to form the arbitrarily shaped 3D micro- and nano structures. The selective etch is based on the fact that high concentration doping (e.g. by Ga for p+ doping in Si) in silicon and other semiconductors drastically reduces the etch rate to certain etchants (including dry and wet etchants) for example the etching of potassium hydroxide (KOH) of silicon in the implanted regions. In addition, alternative implantation techniques and material combinations based on direct FIB or laser writing can be used to create multi-layer structures. Such structures can subsequently be selectively etched to create free-form 3D MEMS, NEMS and photonic structures.

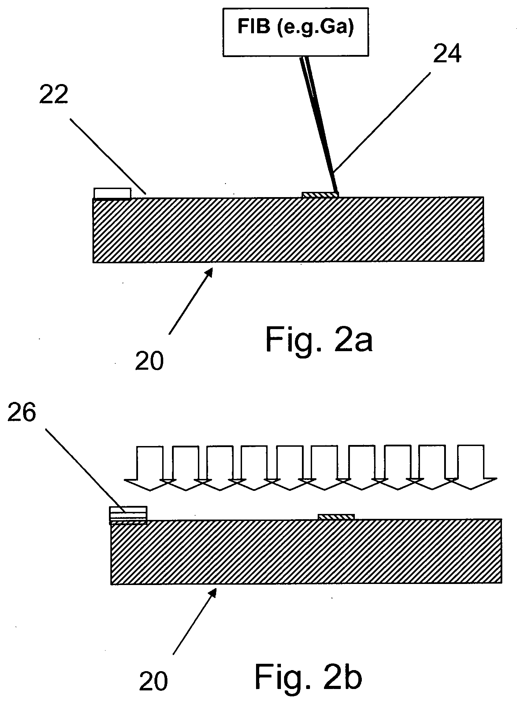

Figure 2a-f illustrates one embodiment of the new process schemes for free-form 3D printing of mono-crystalline silicon micro- and nanostructures according to the present invention.

In this process scheme, a substrate wafer 20 is provided with a first layer of mono-crystalline silicon 22. The substrate wafer 20 can be a semiconductor wafer, such as a silicon wafer, preferably mono-crystalline or a silicon-on-insulator (SOI) wafer.

The first layer 22 of mono-crystalline silicon is locally exposed with a focussed ion beam 24 using a standard Ga ion source as shown in Figure 2a. Thus, a thin Si layer (a few tens of nm thick) is implanted with Ga ions to a depth of minimum 1 nm, suitably 5 nm, maximium 5 micrometers, more suitably 10 - 300 nm, preferably 20 - 70 nm.

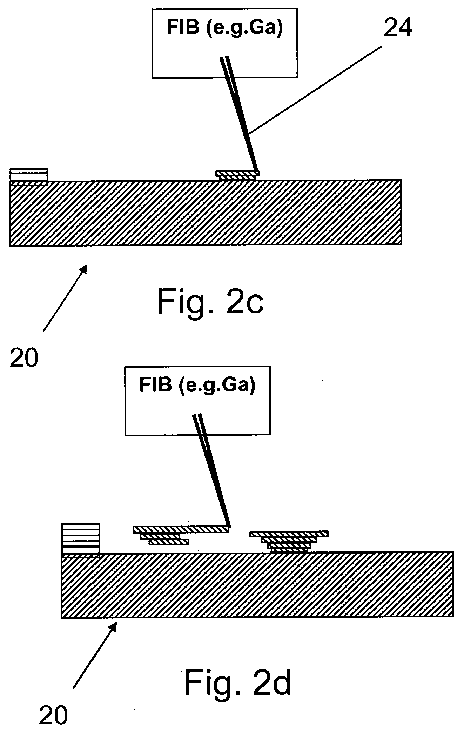

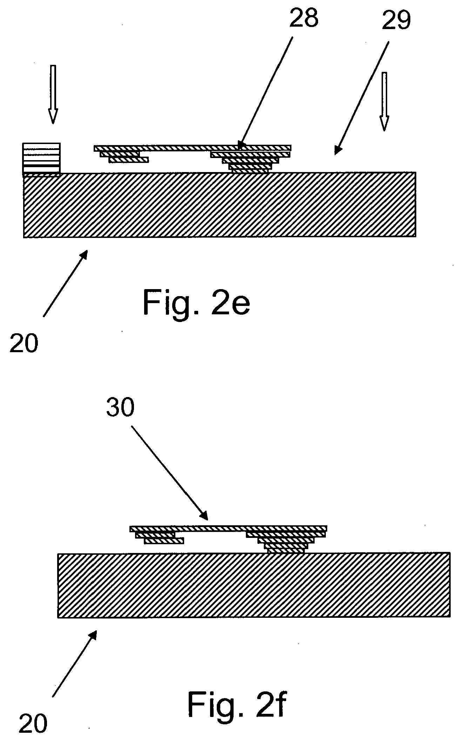

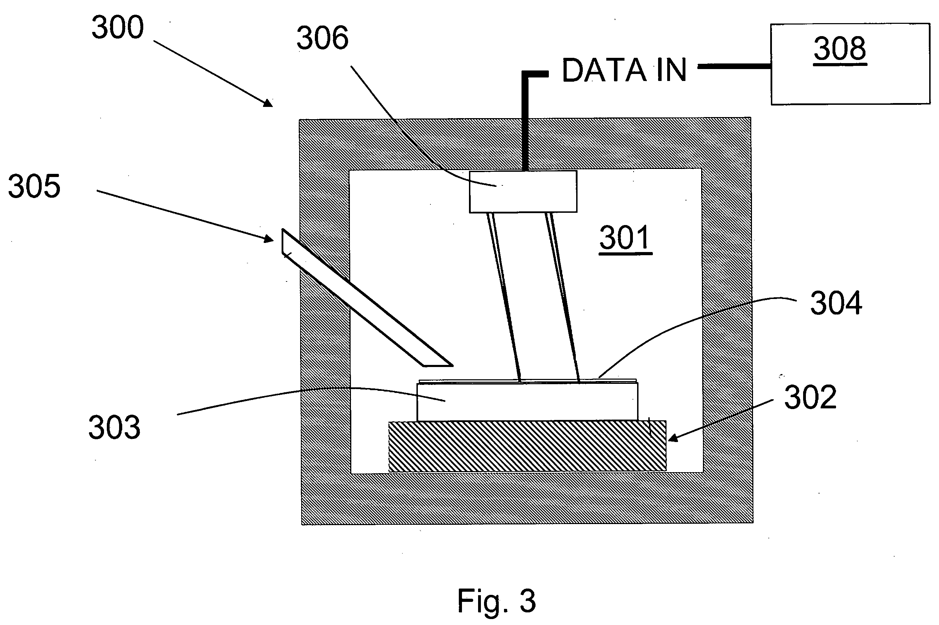

Thereafter, a further thin layer (a few tens of nm thick, e.g. minimum 1 nm, suitably 5 nm, maximium 5 micrometers, more suitably 10 - 300 nm, preferably 20 - 70 nm) 26 of mono-crystalline Si is grown epitaxially on the substrate surface as shown in Figure 2b, the growth being indicated by the arrows in Figure 2b. This Si layer 26 is then again locally exposed with the focussed ion beam 24, illustrated in Fig. 2c. The steps shown in Figure 3a-c are repeated until a full 3D micro-structure is defined. Fig. 2d illustrates a final exposing step being performed, and the final result of the sequence of repeated exposures and irradiations is indicated in Fig. 2e as embedded layers 28 of ion implanted silicon in layers 29 of pure silicon.

Thereafter, the silicon that was not exposed to the focused ion beam is sacrificially etched suitably using KOH wet etching, wet Tetramethylammonium hydroxide (TMAH) etching, a wet ethylene diamine pyrochatechol etch (EDP), or a deep reactive ion etch (DRIE), schematically indicated with arrows in Fig. 2e, thereby free-etching the FIB-defined 3D microstructure 30, shown in Fig. 2f. This can be achieved because the Si that has previously been exposed to the FIB is more resistant to the etching processes as compared to the unexposed silicon. The silicon epitaxy process steps and the ion implantation with FIB direct writing can be done in two separate tools in an iterative process, which is a somewhat tedious process. However, preferably a practical implementation of this approach involves that both the silicon epitaxy process steps and the ion implantation with FIB direct writing are implemented as a fully automated switched process in a single tool. This will allow a throughput that is suitable for at least prototyping of 3D MEMS, NEMS and photonic crystal structures. The selective etching for the definition of the 3D microstructures can be easily implemented in a final process step outside the tool.

The above example of a process scheme according to the invention is but one possible embodiment of the invention.

Variations are possible within the inventive concept.

For example, the substrate wafer need not strictly be a mono-crystalline wafer, but could be poly-crystalline as well. It is also possible to provide the subsequent layers in the form of poly-crystalline material and even amorphous material. Thus, the layers that are deposited can be formed from to mono-crystalline Si, poly-crystalline Si amorphous Si and SiGe in mono-crystalline, poly-crystalline or amorphous forms. Combinations of layer materials would also be possible and within the scope of the invention.

The focussed ion beam, although it is preferred to use Ga ions, could employ other ions such as In ions, Hydrogen ions, Helium ions and other ions, such as Argon, Xenon or other ions that create suitable doping in the selected semiconductor material that make it etch resistant to the selected etchant.

Deposition of the thin consecutive material layers can be performed by other methods than epitaxial growth, such as chemical vapour deposition or physical vapour deposition.

The proposed basic concepts according to the invention for manufacturing arbitrarily shaped silicon 3D MEMS, NEMS and photonic crystal structures will trigger an entirely new paradigm in the manufacturing of micro and nanostructures such as MEMS and NEMS.

Specifically 3D photonic crystals made of mono-crystalline silicon for telecommunication and sensor applications would greatly benefit due to the high refractive index and transparency of mono-crystalline silicon. Potential MEMS and NEMS applications include three-axis inertial sensors that have identical sensitivity on all three measurement axis.

There is also a huge potential for exploring new material combinations, FIB- and laser-based implantation, layering and deposition techniques along with selective etching techniques.

The methods according to the invention enables the fabrication of extremely advanced 3D MEMS, NEMS and photonic components consisting of a combination of high-quality mono-crystalline, poly-crystalline and amorphous semiconductor materials that can be combined with FIB assisted deposition of metals and isolators.

Highly parallel FIB direct writing with arrayed beams in combination with Si epitaxial deposition can be used to define the layered structures for 3D micro and nanostructure manufacturing and increase the throughput to levels that allow low-volume manufacturing at acceptable costs. Thus, manufacture of arbitrarily shaped 3D micro- and nano-components made of high-performance materials is made possible due to the resent invention. Ultimately, this could lead to a new paradigm for the fabrication of micro- and nanostructures.

### EXAMPLES

A standard silicon waferis locally exposed by a focussed Ga ion beam using a FIB apparatus (FEI Nova 600 NanoLab) with a dose of 5.6E+15 ions/cm2 at an acceleration voltage of 30 kV and a focussed ion beam current of 100pA. In this way structures are defined by local ion implantation. These structures can have lateral critical dimensions from 10 nm to the µm range. Thereafter the exposed silicon surface is annealed at 650°C (alternatively at 1100°C) to recrystallize the amorphous silicon surface and cleaned using standard HF and Pyrania clean. Thereafter a 30 nm thick Si layer is epitaxially grown on the wafer surface at 635°C using a standard epitaxial process. The above described processes of FIB writing and Si epitaxial growth are repeated 10 times. Finally, the Si wafer is etched in a 30% KTH bath at room temperature for 30 minutes. Thereby all the Si surface that is not implanted with the Ga ions is etched selectively to a depth of 500nm, leaving the Ga ion implanted region unetched by the KTH and thus forming 3D Si structures.

Although the method has been exemplified an discussed primarily with reference to silicon and SiGe in various forms, the method according to the invention is applicable in general to semiconductor materials and thus, 3D structures can be made by selecting appropriate ions for implanting and correspondingly appropriate etching processes for free etching the structures defined.

In a further aspect of the invention there is provided an apparatus for performing the method described herein, i.e. for making a three-dimensional structure in semiconductor material. It comprises a vacuum chamber 301; provided inside said vacuum chamber i) a mounting means for a semi-conductor substrate 303; ii) at least one foucssed ion beam device 306; ii) means 305 for enabling deposition of semiconductor material; a control unit 308 for executing a translation of design data to write instructions to the focussed ion beam device 306, and for sending the instructions to the focussed ion beam device 306. The deposition means 305 is adapted for enabling epitaxial growth of the semiconductor material.

In a preferred embodiment, it accommodates, in alternating process steps, Si epitaxial deposition and FIB writing using one or several parallel FIB beams inside the same vacuum chamber without removing the sample substrate from the tool.

The apparatus according to the invention, schematically shown in Fig. 3 and generally designated 300, comprises a vacuum chamber 301 in which all operations are performed. There is also provided a temperature-controlled chuck 302 on which a substrate, e.g. in the form of a Si wafer 303, is placed, the chuck stabilizing the substrate at the Si epitaxial growth temperature during the epitaxial Si deposition to provide consecutive layers 304. It also comprises gas supplies 305 that provide the gasses for the epitaxial growth process in a controlled flow condition.

The apparatus further comprises one or more parallel FIBs 306 for the writing of the layered structures. These FIB sources are arranged or protected in such a way that the epitaxial gasses and the involved temperatures do not affect or destroy the FIB sources. In case several parallel FIBs are used, all individual beams write in parallel the same pattern based on the same CAD data. In this way, the total data rate is limited to manageable level, while still providing high throughput by highly parallel FIB writing of many identical 3D structures.

The apparatus is controlled by software run in a control unit 308 that translates a 3D CAD model of a 3D structure into many slices (layers), and data DATA IN representing such structure is sent to the apparatus which then subsequently writes the structures with the FIB in the epitaxially deposited Si layers, while automatically new layers are being epitaxially deposited in between the FIB writing process. The apparatus also preferably has means for providing temperatures (via the chuck) and gasses to the chamber that allow an automated annealing step for the Si or SiGe layer(s) after the FIB writing of each layer.

## Claims

1. A method of making a three-dimensional structure in semiconductor material, comprising the steps of:
providing a substrate (20) having at least a surface comprising semiconductor material (22);
exposing optionally selected areas of the surface of the substrate to a focussed ion beam (24) whereby the ions are implanted in the semiconductor material (22) in said selected areas;
depositing a layer (26) of a material selected from the group consisting of mono-crystalline, poly-crystalline or amorphous semiconductor material, on the substrate surface;
repeating the steps of exposing to a focussed ion beam (24) and depositing material until a desired structure is defined by the exposed areas;
selective etching of material in the structure defined by the focussed ion beam so as to provide a three-dimensional structure.

2. The method as claimed in claim 1, wherein the semiconductor material in the substrate is silicon or SiGe and is mono-crystalline, poly-crystalline silicon or amorphous.

3. The method as claimed in claim 1 or 2, wherein the substrate is a semiconductor wafer, preferably a silicon wafer or a SOI wafer.

4. The method as claimed in claim 1, 2 or 3, wherein the deposition of the material is performed by any of epitaxially growing the material, chemical vapour deposition or physical vapour deposition.

5. The method as claimed in claim 1, 2, 3 or 4, wherein the focussed ion beam comprises ions selected from the group consisting of Ga, In, H and He, Argon Xenon.

6. The method as claimed in any preceding claim, wherein the deposited layers are minimum 1 nm, suitably 5 nm, maximium 5 micrometers, more suitably 10 - 300 nm, preferably 20 - 70 nm thick.

7. The method as claimed in any preceding claim, wherein the ions are implanted to a depth of minimum 1 nm, suitably 5 nm, maximium 5 micrometers, more suitably 10 - 300 nm, preferably 20 - 70 nm.

8. The method as claimed in any preceding claim, wherein the etching is performed as any of a wet KOH etch, a wet Tetramethylammonium hydroxide (TMAH) etch, a wet ethylene diamine pyrochatechol etch (EDP), or a deep reactive ion etch (DRIE).

## Patentansprüche

1. Ein Verfahren zur Herstellung einer dreidimensionalen Struktur in einem Halbleitermaterial, aufweisend die Schritte von:
Bereitstellen eines Substrats (20) mit wenigstens einer Oberfläche, die Halbleitermaterial (22) aufweist;
Aussetzen von optional ausgewählten Bereichen der Oberfläche des Substrats gegenüber einem fokussierten Ionenstrahl (24), wobei die Ionen in das Halbleitermaterial (22) in den besagten ausgewählten Bereichen implantiert werden;
Ablegen einer Schicht (26) eines Materials ausgewählt aus der Gruppe bestehend aus monokristallinem, polykristallinem oder nicht kristallinem Halbleitermaterial auf der Substratoberfläche;
Wiederholen der Schritte von einem Aussetzen gegenüber einem fokussierten Ionenstrahl (24) und einem Ablegen von Material bis eine gewünschte Struktur durch die exponierten Bereiche definiert ist;
selektives Ätzen von Material in der durch den fokussierten lonenstrahl definierten Struktur, um eine dreidimensionale Struktur bereitzustellen.

2. Das Verfahren wie in Anspruch 1 beansprucht, wobei das Halbleitermaterial in dem Substrat Silizium oder SiGe ist und monokristallin, polykristallin oder nicht kristallin ist.

3. Das Verfahren wie in Anspruch 1 oder 2 beansprucht, wobei das Substrat ein Halbleiterplättchen, bevorzugt ein Siliziumplättchen oder ein SOI-Plättchen, ist.

4. Das Verfahren wie in Anspruch 1, 2 oder 3 beansprucht, wobei die Ablage des Materials durchgeführt wird durch eines von einem epitaktischen Aufwachsen des Materials, einer chemischen Abscheidung aus der Gasphase oder einer physikalischen Abscheidung aus der Gasphase.

5. Das Verfahren wie in Anspruch 1, 2, 3 oder 4 beansprucht, wobei der fokussierte Ionenstrahl Ionen ausgewählt aus der Gruppe bestehend aus Ga, In, H und He, Argon, Xenon aufweist.

6. Das Verfahren wie in einem vorangegangenen Anspruch beansprucht, wobei die abgelegten Schichten minimal 1 nm, geeignet 5 nm, maximal 5 Mikrometer, noch geeigneter 10 - 300 nm, bevorzugt 20 - 70 nm dick sind.

7. Das Verfahren wie in einem vorangegangenen Anspruch beansprucht, wobei die Ionen in einer Tiefe von minimal 1 nm, geeignet 5 nm, maximal 5 Mikrometer, noch geeigneter 10 - 300 nm, bevorzugt 20 - 70 nm implantiert werden.

8. Das Verfahren wie in einem vorangegangenen Anspruch beansprucht, wobei das Ätzen durchgeführt wird als eines von einer KOH-Nassätzung, einer Tetramethylammoniumhydroxid-(TMAH)-Nassätzung, einer Ethylen Diamin Pyrochatechol Nassätzung (EDP) oder einer reaktiven Ionentiefenätzung (DRIE).

## Revendications

1. Procédé de fabrication d'une structure tridimensionnelle en un matériau semi-conducteur, comprenant les étapes suivantes :
la fourniture d'un substrat (20) ayant au moins une surface comprenant un matériau semi-conducteur (22) ;
l'exposition de zones éventuellement choisies de la surface du substrat à un faisceau d'ions focalisé (24), moyennant quoi les ions sont implantés dans le matériau semi-conducteur (22) dans lesdites zones choisies ;
le dépôt d'une couche (26) constituée d'un matériau choisi dans le groupe constitué d'un matériau semi-conducteur monocristallin, polycristallin ou amorphe, sur la surface du substrat ;
la répétition des étapes d'exposition à un faisceau d'ions focalisé (24) et de dépôt de matériau jusqu'à ce qu'une structure souhaitée soit définie par les zones exposées;
la gravure sélective du matériau dans la structure définie par le faisceau d'ions focalisé de façon à obtenir une structure tridimensionnelle.

2. Procédé selon la revendication 1, dans lequel le matériau semi-conducteur dans le substrat est du silicium ou du SiGe et est un silicium monocristallin, polycristallin ou amorphe.

3. Procédé selon la revendication 1 ou 2, dans lequel le substrat est une tranche de semi-conducteur, de préférence une tranche de silicium ou une tranche de SOI.

4. Procédé selon la revendication 1, 2 ou 3, dans lequel le dépôt du matériau est réalisé par l'un quelconque parmi la croissance épitaxiale du matériau, le dépôt chimique en phase vapeur ou le dépôt physique en phase vapeur.

5. Procédé selon la revendication 1, 2, 3 ou 4, dans lequel le faisceau d'ions focalisé comprend des ions choisis dans le groupe constitué de Ga, In, H et He, argon et xénon.

6. Procédé selon l'une quelconque des revendications précédentes, dans lequel les couches déposées ont au minimum 1 nm, convenablement 5 nm, au maximum 5 micromètres, plus convenablement 10 à 300 nm, de préférence de 20 à 70 nm, d'épaisseur.

7. Procédé selon l'une quelconque des revendications précédentes, dans lequel les ions sont implantés à une profondeur d'au minimum 1 nm, convenablement de 5 nm, d'au maximum 5 micromètres, plus convenablement de 10 à 300 nm, de préférence de 20 à 70 nm.

8. Procédé selon l'une quelconque des revendications précédentes, dans lequel la gravure est réalisée sous la forme de l'une quelconque parmi une gravure au KOH par voie humide, une gravure à l'hydroxyde de tétraméthylammonium par voie humide (TMAH), une gravure au pyrochatéchol d'éthylène diamine par voie humide (EDP), ou une gravure par ions réactifs profonde (DRIE).
